# FASCICULE DE BREVET EUROPEEN

(11) **EP 1 431 772 B1**
(45) Date de publication et mention de la délivrance du brevet: **29.08.2007**
(21) Numéro de dépôt: 03104376.3
(22) Date de dépôt: 26.11.2003
(51) Int. Cl.: G01S 7/03, H03G 11/02

(54) **Limiteur de puissance pour radar**
Radar Leistungsbegrenzer
Radar power limiter

(30) Priorité: 17.12.2002 FR 0216004
(43) Date de publication de la demande: 23.06.2004
(73) Titulaire: Thales, 92526 Neuilly Sur Seine (FR)
(72) Inventeur: TOLANT, Clément, 94117 Cedex, ARCUEIL (FR); EUDELINE, Philippe, 94117 Cedex, ARCUEIL (FR); DURIEUX, Franck, 94117 Cedex, ARCUEIL (FR); STANISLAWIAK, Michel, 94117 Cedex, ARCUEIL (FR)
(74) Mandataire: Lucas, Laurent Jacques

(56) Documents cités:
- EP-A- 1 069 679
- US-A- 5 300 900
- US-A- 5 521 560
- COFFMAN Z E ET AL: "Low cost plastic packaging for high-power limiters" IEEE 11TH TOPICAL MEETING ON ELECTRICAL PERFORMANCE OF ELECTRONIC PACKAGING (CAT. NO.02TH8619), IEEE 11TH TOPICAL MEETING ON ELECTRICAL PERFORMANCE OF ELECTRONIC PACKAGING, MONTEREY, CA, USA, 21-23 OCT. 2002, pages 79-82, XP010616634 2002, Piscataway, NJ, USA, IEEE, USA ISBN: 0-7803-7451-7
- SEYMOUR D J ET AL: "X-band monolithic GaAs PIN diode variable attenuation limiter" IEEE, 8 mai 1990 (1990-05-08), pages 841-844, XP010004578
- FENG YANMIN: "The power handling capability of larger power microwave active limiter" ICMMT 2000. 2000 2ND INTERNATIONAL CONFERENCE ON MICROWAVE AND MILLIMETER WAVE TECHNOLOGY PROCEEDINGS (CAT. NO.00EX364), PROCEEDINGS OF INTERNATIONAL CONFERENCE ON MICROWAVE AND MILLIMETER WAVE TECHNOLOGY, BEIJING, CHINA, 14-16 SEPT. 2000, pages 572-574, XP001180624 2000, Piscataway, NJ, USA, IEEE, USA ISBN: 0-7803-5743-4
- SMITH D G ET AL: "Designing high-power limiter circuits with GaAs PIN diodes" MICROWAVE SYMPOSIUM DIGEST, 1999 IEEE MTT-S INTERNATIONAL ANAHEIM, CA, USA 13-19 JUNE 1999, PISCATAWAY, NJ, USA,IEEE, US, 13 juin 1999 (1999-06-13), pages 329-332, XP010343531 ISBN: 0-7803-5135-5

## Description

La présente invention concerne un limiteur de puissance de signal hyperfréquence. Elle s'applique notamment aux radars fonctionnant en bande S afin de protéger les amplificateurs faible bruit de la chaîne de réception contre des signaux hyperfréquences de puissance trop élevée.

Alors qu'une voie émission de radar classique peut véhiculer des signaux de très forte puissance, par exemple de l'ordre de quelques kilowatts de puissance crête, la voie de réception ne traite en revanche que des signaux de très faible niveau, par exemple au maximum de quelques milliwatts. En limite de détection du radar, la puissance réémise par une cible et détectée par le radar est très faible. Il est donc important que les composants de la chaîne de réception, et notamment les amplificateurs, présentent eux-mêmes un bon facteur de bruit afin de ne pas dégrader la dynamique du système. En contrepartie ces composants ne supportent généralement pas des niveaux de puissance élevée, même transitoires et offrent un seuil de vulnérabilité proche de 20 dBm. Il est donc nécessaire de prévoir des dispositifs de limitation de puissance dans les voies de réception pour s'affranchir des différentes menaces.

Le module émission-réception comprend généralement un duplexeur de puissance chargé d'assurer l'aiguillage entre les différentes voies. C'est un élément à trois ports, laissant passer les signaux de la chaîne d'émission vers l'antenne et véhiculant les signaux reçus de l'antenne vers la chaîne de réception. Bien qu'adapté dans la bande de fréquence utile, le duplexeur ne présente pas une isolation parfaite, c'est-à-dire qu'une partie du signal émis se trouve par exemple sur la voie de réception. Cette fuite de puissance résiduelle est généralement accompagnée par des signaux d'amplitude plus élevée issus par exemple de la désadaptation de l'élément rayonnant et du couplage entre des éléments rayonnants dans les antennes à réseau. Ces deux effets conjugués représentent la menace interne pour le récepteur. La menace externe est causée par exemple par la présence de brouilleurs, de signaux dus à des radars proches ou encore à des échos forts provenant de cibles fixes.

Les émetteurs radar dits à état solide regroupent généralement un nombre élevé de transistors de puissance. Cette technologie est notamment utilisée pour réduire les coûts tout en améliorant la fiabilité du système. Ce type d'émission est présent notamment dans les antennes réparties ou semi-réparties, où on la retrouve associée à des chaînes de réception comprenant des limiteurs moyenne puissance très compacts de type actif ou passif.

Un limiteur passif comprend une ou plusieurs diodes de limitation de type P.I.N. placées en parallèle sur une ligne de propagation. La tenue en puissance de ces limiteurs passifs est faible car la résistance équivalente des diodes P.I.N. en régime de conduction n'atteint pas sa valeur minimale. Cet effet se traduit par un échauffement des diodes placées sur l'étage de puissance c'est-à-dire en entrée du limiteur.

Les limiteurs actifs permettent de s'affranchir de cet inconvénient et d'avoir notamment des tenues en puissance plus élevées. Leur principe repose sur l'injection d'un courant de polarisation dans la ou les diodes P.I.N. de l'étage de puissance afin d'amener leur résistance équivalente à un niveau minimal. Parmi les principales architectures de limiteurs actifs, nous trouvons les structures absorptives et réflexives.

Les structures absorptives comprennent un circuit auxiliaire avec une diode de commutation associée à une charge 50 ohms de puissance qui absorbe l'énergie réfléchie par les diodes P.I.N. de puissance quand elles entrent en régime de conduction. Ces structures absorptives présentent des pertes d'insertion bas niveau élevées, elles sont donc rarement utilisées pour les applications radar.

Les structures réflexives dans lesquelles l'énergie incidente est totalement réfléchie en entrée sont beaucoup plus utilisées. Il existe notamment deux grandes familles de structures réflexives : les structures semi-actives, et les structures actives, plus récentes.

Une structure semi-active injecte un courant de polarisation dans les diodes P.I.N. au moyen d'un circuit extérieur. Ceci permet de limiter la puissance dissipée dans les diodes tout en limitant leur échauffement. En mode réception, l'injection du courant de polarisation est le plus souvent synchronisée avec l'émission des pulses. La valeur du courant de polarisation est de l'ordre de quelques dizaines de milliampères et peut être déterminée en fonction du niveau d'émission du radar. En mode réception, ce courant de polarisation doit être nul afin de garantir au limiteur des pertes d'insertion minimales.

Le limiteur de structure semi-active assure une bonne limitation en mode réception pour la menace interne correspondant à l'émission du radar. Cependant, il ne permet pas d'assurer une limitation optimale pour une menace dont le niveau n'est pas connu d'avance. Le limiteur semi-actif ne permet pas la protection du récepteur contre des menaces externes dont le niveau et le moment d'apparition sont en général imprévisibles. Il ne permet notamment pas de protéger le récepteur lors d'un brouillage ennemi apparaissant en phase réception, c'est à dire entre les pulses émis.

Une structure active comprend généralement un circuit auxiliaire comprenant un coupleur associé à un détecteur, le détecteur répondant à la puissance incidente à son entrée. Le rôle du circuit coupleur-détecteur est de transformer une partie de la puissance hyperfréquence incidente arrivant sur le limiteur en un courant de polarisation, qui sera injecté dans les diodes P.I.N. d'un premier étage de puissance du limiteur. Une telle structure est notamment décrite dans la demande de brevet français n°9909276 déposée le 16.07.1999, publiée sous le n° 2 796 508, ainsi que dans le brevet US 5,300,900 de J. V. Bellantoni et Al. Délivré le 5 avril 1994.

Le limiteur de structure active assure une protection pour des menaces inconnues, car il génère lui-même le courant de polarisation des diodes P.I.N. en fonction de la puissance hyperfréquence incidente. Cependant, sa tenue en puissance peut être améliorée.

De plus, on peut être confronté à la présence de raies parasites générées par le limiteur lui-même. En effet, le circuit secondaire d'injection et le circuit principal de limitation comprennent chacun des éléments non linéaires : les diodes de détection de type SCHOTTKY et de limitation de type P.I.N.. La transition d'une de ces diodes peut provoquer celle de l'autre, qui à son tour peut provoquer une transition de la première dans l'autre sens. On est ainsi en présence d'une boucle pouvant osciller et produire des raies parasites. Ceci est particulièrement gênant lorsque le radar est en mode d'émission car le spectre d'émission peut être pollué.

Un but de l'invention est de disposer d'un limiteur présentant les avantages des limiteurs actifs, mais qui ne pollue pas le spectre en mode d'émission.

A cet effet l'invention concerne un limiteur de puissance hyperfréquence, comprenant :
- une ligne principale avec une entrée et une sortie, l'entrée recevant un signal hyperfréquence incident,
- un premier étage de limitation, inséré dans la ligne principale, formé par une ou plusieurs diodes,
- un circuit détecteur avec une entrée et une sortie, le circuit détecteur générant à sa sortie un courant répondant à la puissance du signal hyperfréquence appliqué à son entrée, l'entrée du circuit détecteur recevant une fraction du signal hyperfréquence incident, le circuit détecteur étant agencé de manière à polariser les diodes du premier étage de limitation avec le courant généré à sa sortie,
- une entrée de polarisation, l'entrée de polarisation recevant un courant de polarisation externe, l'entrée de polarisation étant agencée de manière à polariser les diodes du premier étage de limitation avec le courant de polarisation externe.
Selon l'invention, l'entrée de polarisation est reliée à des moyens pour générer un courant de polarisation synchronisé avec les impulsions du signal d'émission du radar.

Selon une caractéristique avantageuse de l'invention, l'entrée de polarisation est reliée au circuit détecteur.

Selon une caractéristique avantageuse de l'invention, le courant de polarisation externe et le courant généré à la sortie du circuit détecteur sont transmis à la ligne principale par l'intermédiaire d'un circuit de polarisation comportant une ligne et une capacité de découplage, la ligne présentant sensiblement une longueur d'un quart de longueur d'onde à la fréquence moyenne de la bande utile du limiteur.

Selon une caractéristique avantageuse de l'invention, les diodes du premier étage de limitation sont situées entre un premier et un second tronçons d'adaptation de la ligne principale, le premier tronçon d'adaptation, à l'entrée du limiteur, étant désadapté de la ligne principale.

Selon une caractéristique avantageuse de l'invention, le second tronçon d'adaptation assure à sa sortie une réadaptation de la ligne principale à l'impédance de la ligne de propagation en entrée du limiteur.

Selon une caractéristique avantageuse de l'invention, le premier tronçon d'adaptation présente sensiblement une longueur d'un quart de longueur d'onde à la fréquence moyenne de la bande utile du limiteur. Selon une caractéristique avantageuse de l'invention, le circuit détecteur comprend une ou plusieurs diodes de type SCHOTTKY.

Selon une caractéristique avantageuse de l'invention, le limiteur comprend en outre un second étage de limitation, inséré dans la ligne principale entre le premier étage de limitation et la sortie du limiteur.

Selon une caractéristique avantageuse de l'invention, l'entrée du circuit détecteur est couplée à la ligne principale de manière à prélever une fraction du signal hyperfréquence incident.

Selon un autre mode de réalisation avantageux de l'invention, le circuit détecteur est relié à la ligne principale entre le premier étage de limitation et la sortie du limiteur, la ou les diodes du circuit détecteur formant les diodes du second étage de limitation.

L'invention concerne aussi l'utilisation d'un tel limiteur.

L'invention présente l'avantage d'assurer une tenue en puissance maximale, aussi bien en modes émission et réception.

L'invention présente l'avantage d'assurer une limitation pour des puissances dont la valeur est inconnue a priori du radar, la limitation est notamment assurée lors d'un brouillage.

L'invention présente l'avantage d'assurer aussi une limitation pour des puissances élevées lors de l'émission du radar, la limitation est notamment assurée en cas de couplage parasite entre des éléments rayonnants voisins d'une antenne à réseau.

L'invention présente l'avantage d'assurer une isolation maximale entre les voies d'émission et de réception d'un module d'émission-réception (TR-module).

L'invention permet en mode réception de transformer le limiteur en atténuateur variable de précision par modification d'un courant de polarisation externe.

L'ensemble du circuit est particulièrement compact, sa surface est d'environ quelques centimètres carrés.

D'autres caractéristiques et avantages de l'invention apparaîtront à la lecture de la description détaillée suivante présentée à titre d'illustration non limitative et faite en référence aux figures annexées, lesquelles représentent :
- la figure 1, un exemple de module d'émission/réception radar ;
- la figure 2, un premier exemple de réalisation d'un limiteur selon l'invention sous la forme d'un schéma synoptique ;
- la figure 3, l'exemple de la figure 2 sous forme plus détaillée ;
- la figure 4, un second exemple de réalisation d'un limiteur selon l'invention sous la forme d'un schéma synoptique.

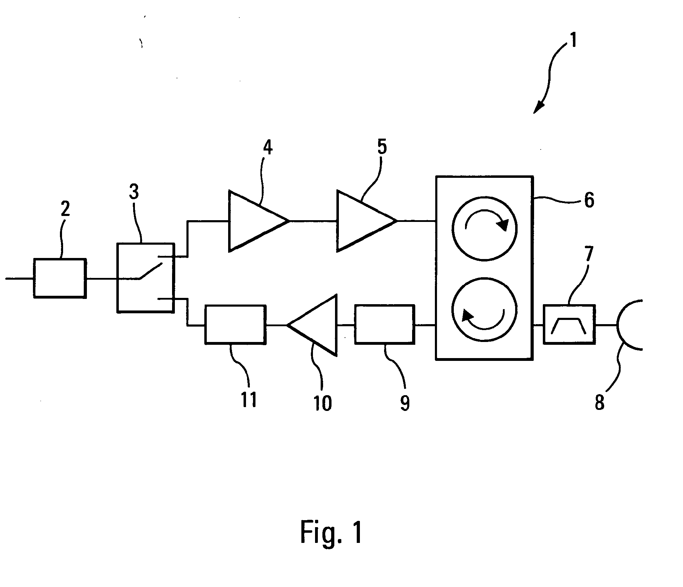

On se réfère maintenant à la figure 1 sur laquelle est représenté un exemple de module d'émission-réception radar 1 ou TR-module. Ce module comprend une chaîne d'émission et une chaîne de réception, reliant un déphaseur 2 à un élément rayonnant 8. Ces chaînes sont reliées par un commutateur 3 du côté du déphaseur 2. Elles sont reliées par un circulateur/duplexeur 6 du côté de l'élément rayonnant 8. Un filtre passe bande (bande S par exemple) est placé entre le circulateur/duplexeur 6 et l'élément rayonnant 8. La chaîne d'émission comprend, dans le sens de propagation du signal hyperfréquence, un pré-amplificateur 4 et un amplificateur haute puissance 5. La chaîne de réception comprend, dans le sens de propagation du signal hyperfréquence, un limiteur de puissance 9, un amplificateur faible bruit 10, et un atténuateur 11.

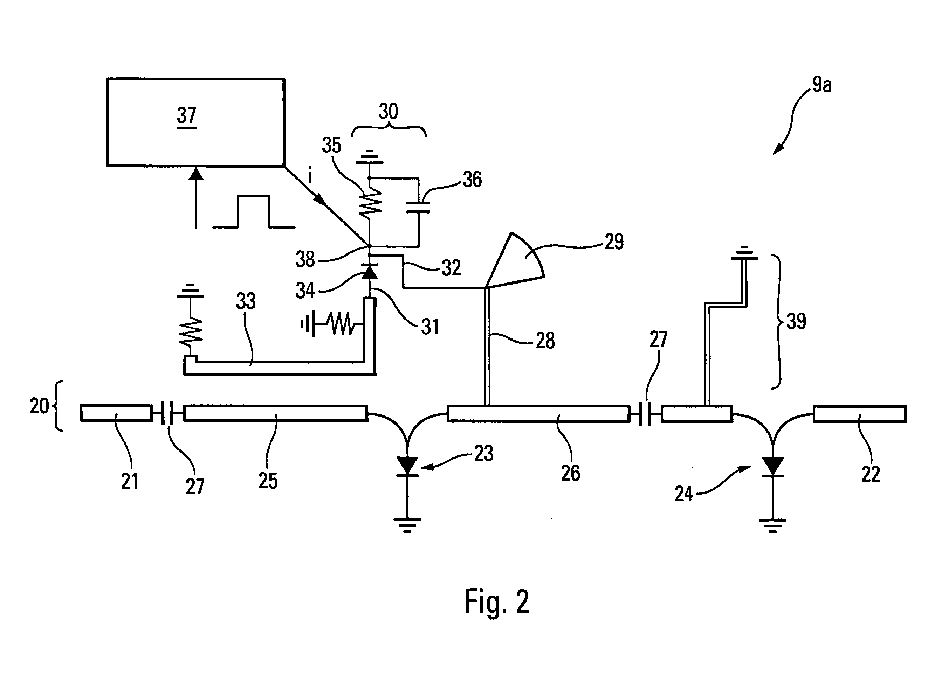

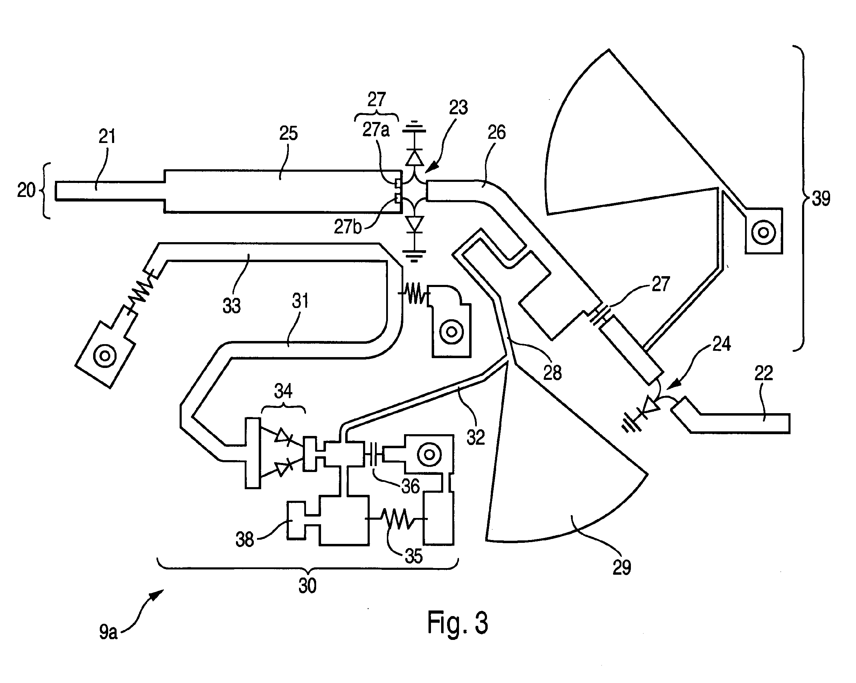

On se réfère maintenant aux figure 2 et 3 sur lesquelles est représenté un premier exemple de réalisation d'un limiteur 9a selon l'invention. Le limiteur 9a comprend un circuit principal et un circuit secondaire, couplé au circuit principal.

Le circuit principal comprend une ligne de propagation principale 20. Cette ligne comprend une entrée 21 et une sortie 22, formant l'entrée et la sortie du limiteur, entre lesquelles est assurée une limitation de la puissance. L'entrée 21 reçoit le signal hyperfréquence incident. Un premier étage de limitation 23 est inséré dans la ligne principale 20. Le premier étage de limitation 23 est formé par une ou plusieurs diodes P.I.N en parallèle, permettant de limiter la puissance.

Le premier étage 23 de limitation comporte de préférence deux ou trois diodes. Le premier étage est un étage de puissance, en fonctionnement il assure par exemple une division par cent de la puissance reçue. La présence de plusieurs diodes permet d'assurer une meilleure tenue en puissance, la puissance dissipée étant répartie sur les diodes. Les diodes P.I.N. ont de préférence une zone I importante, leur capacité de jonction est élevée. Les diodes P.I.N. sont de préférence des diodes brasées à haute température, cela présente l'avantage de limiter leur échauffement. Les diodes P.I.N. sont de préférence reportées, par exemple par brasage ou par soudure eutectique, sur un refroidisseur, non représenté. Le refroidisseur est par exemple en cuivre ou de préférence en diamant synthétique, il permet de réduire l'échauffement des diodes. Les diodes du premier étage 23 de limitation sont connectées à la ligne de propagation hyperfréquence par des fils de préférence en or.

Le circuit secondaire comprend un coupleur 33 et un circuit détecteur 30. Une fraction du signal hyperfréquence à l'entrée 21 du limiteur est transmise par couplage hyperfréquence au circuit détecteur 30 au moyen du coupleur 33.

Le coupleur 33 présente une haute directivité et un couplage de l'énergie réfléchie qui est plat dans la bande de fréquence. La longueur du coupleur 33 est de préférence égale au quart d'onde.

Le circuit détecteur 30 comprend une entrée 31 et une sortie 32. L'entrée 31 du circuit détecteur reçoit la fraction du signal prélevé. Le circuit détecteur génère à sa sortie 32 un courant répondant à la puissance du signal hyperfréquence appliqué à son entrée 31. La sortie 32 du circuit détecteur est reliée au premier étage de limitation, de manière à polariser les diodes P.I.N. avec le courant généré en sortie du circuit détecteur 30. L'énergie couplée par le coupleur 33 est donc transformée en un courant continu par le circuit détecteur 30.

Le circuit détecteur comprend une ou, de préférence, plusieurs diodes 34 de type SCHOTTKY, de préférence MEDIUM BARRIER, ce type de diodes présentant de bonnes caractéristiques de redressement pour générer un courant élevé. Le circuit détecteur comprend également un circuit parallèle RC. Le circuit parallèle RC comprend une résistance 35 et une capacité 36 dont les valeurs sont adaptées pour réaliser un filtre passe bas dont la constante de temps est de quelque périodes.

La présence de plusieurs, par exemple deux, diodes SCHOTTKY permet de tenir une puissance plus élevée. Les diodes SCHOTTKY permettent au circuit détecteur de présenter une dynamique importante compatible de la dynamique de la puissance d'entrée du limiteur, au coefficient de couplage près.

La fraction de signal prélevé est d'autant plus importante que le coupleur 33 est proche de la ligne principale 20. L'espacement entre la ligne principale 20 et le coupleur 33 fournit une valeur de couplage permettant au détecteur de recevoir une puissance inférieure à la limite de tenue en puissance des diodes SCHOTTKY, et cependant suffisante pour faire conduire ces diodes avant l'échauffement au-delà d'une température de dégradation, par exemple 150 degrés, des diodes P.I.N. du premier étage 23 de limitation.

Le coupleur 33 et le circuit détecteur 30 permettent de fournir un courant de polarisation dépendant de la puissance effectivement reçue par le limiteur à son entrée. Le limiteur selon l'invention présente l'avantage de permettre une protection efficace contre des menaces dont la puissance peut être élevée, et dont l'apparition est aléatoire, c'est à dire pouvant arriver aussi bien en mode émission que réception.

Le limiteur comprend aussi une entrée de polarisation 38. L'entrée de polarisation est destinée à recevoir un courant de polarisation i externe.

Le courant de polarisation i externe peut être généré par un générateur de courant 37 commandé par une commande TTL. Le générateur de courant 37 peut ainsi générer un courant continu, par exemple de quelques milliampères, de manière synchronisée avec l'émission des pulses du radar. L'entrée de polarisation 38 est reliée au premier étage de limitation, de manière à polariser les diodes P.I.N. avec le courant de polarisation i externe. On dispose ainsi d'un limiteur ne présentant pas les inconvénients de l'art antérieur.

En appliquant un courant de polarisation i externe continu, il est possible de transformer le limiteur en atténuateur variable de précision. La valeur d'atténuation peut être réglée par modification du courant de polarisation i externe.

Avantageusement, l'entrée de polarisation 38 est reliée au circuit détecteur. Ceci permet d'injecter le courant de polarisation i externe et le courant généré par le circuit détecteur par l'intermédiaire d'un circuit de polarisation unique.

Avantageusement, le circuit de polarisation comprend une ligne 28 et une capacité de découplage 29. La ligne 28 relie la capacité de découplage 29 à un tronçon 26 de la ligne principale 20. En hyperfréquence, la capacité 29 est équivalente à une mise à la masse hyperfréquence. La capacité 29 permet donc de réaliser un découplage hyperfréquence. Avantageusement, la capacité de découplage 29 forme un papillon réalisé en technologie microstrip. Avantageusement, la ligne 28 est une ligne quart d'onde. En hyperfréquence, la ligne 28 et la capacité 29 sont l'équivalent d'un circuit ouvert. Le circuit de polarisation ne créée donc pas de perte ou de perturbation sur la ligne principale 20.

Le limiteur comprend des capacités de liaison 27 insérées sur la ligne principale. Les capacités de liaison 27 sont équivalentes à des courts-circuits en hyperfréquence, et à des circuits ouverts en continu. Les capacités de liaison sont placées de manière à éviter des fuites du courant, destiné à polariser les diodes du premier étage, sur la ligne principale 20. Une première capacité 27 est située du côté de l'entrée 21 du limiteur. Une seconde capacité 27 est située du côté de la sortie 22 du limiteur.

Ces capacités de liaison 27 permettent au courant de polariser les diodes du premier étage 23 de limitation. La polarisation des diodes du premier étage de limitation leur permet de présenter une faible résistance et une puissance dissipée réduite. La polarisation permet aux diodes du premier étage de supporter une puissance incidente beaucoup plus élevée qu'en l'absence de polarisation.

Les capacités de liaison ont une valeur de l'ordre de 30pF par exemple. Elles sont de préférence des capacités monocouche. Elles présentent de très faibles pertes d'insertion et présentent l'avantage de ne pas perturber le fonctionnement hyper du limiteur à bas niveau et notamment lors de la réception de l'écho du signal radar précédemment émis.

Avantageusement, comme représenté sur la figure 3, la première capacité de liaison 27 est formée par des capacités 27a, 27b brasées sur la ligne principale 20, auxquelles sont reliées les diodes P.I.N. du premier étage de limitation 23.

Avantageusement, le limiteur comprend un second étage de limitation 24 avec une ou plusieurs diodes P.I.N.. Ce second étage est situé sur la voie principale 20 entre le premier étage 23 et la sortie 22 du limiteur. La seconde capacité 27 de liaison est placée entre le premier 23 et le second 24 étage de limitation, de manière à ne polariser que les diodes du premier étage de limitation.

Les diodes du second étage 24 de limitation ont une capacité de jonction inférieure à celle des diodes du premier étage 23 de limitation. Les diodes du second étage permettent d'assurer une limitation complétant celle du premier étage, lequel présente un seuil de puissance de conduction assez élevé qui est dû à la capacité de jonction élevée des diodes du premier étage

La composante continue des diodes du second étage 24 de limitation est refermée sur la voie principale 20 au moyen d'un circuit de fermeture 39. Le circuit de fermeture est composé de préférence d'un papillon (dit stub radial), d'un trou métallisé, et d'un quart d'onde situé entre le papillon et la sortie 22 de la voie principale 20. Le circuit de fermeture 39 est facile à réaliser en technologie répartie.

Le circuit détecteur 30 présente une résistance faible. Il permet d'assurer un temps de recouvrement inverse réduit du limiteur, de l'ordre de quelques microsecondes, pendant lequel les porteurs des zones I des diodes du premier étage 23 se vident, les diode du second étage 24 se vidant toujours plus rapidement car sa capacité de jonction est moindre et leur circuit de fermeture 39 est directement relié à la masse par le trou métallisé. Ce temps de recouvrement inverse réduit permet au radar de présenter de bonnes performances de détection des échos proches après la limitation nécessaire pendant l'émission du signal radar.

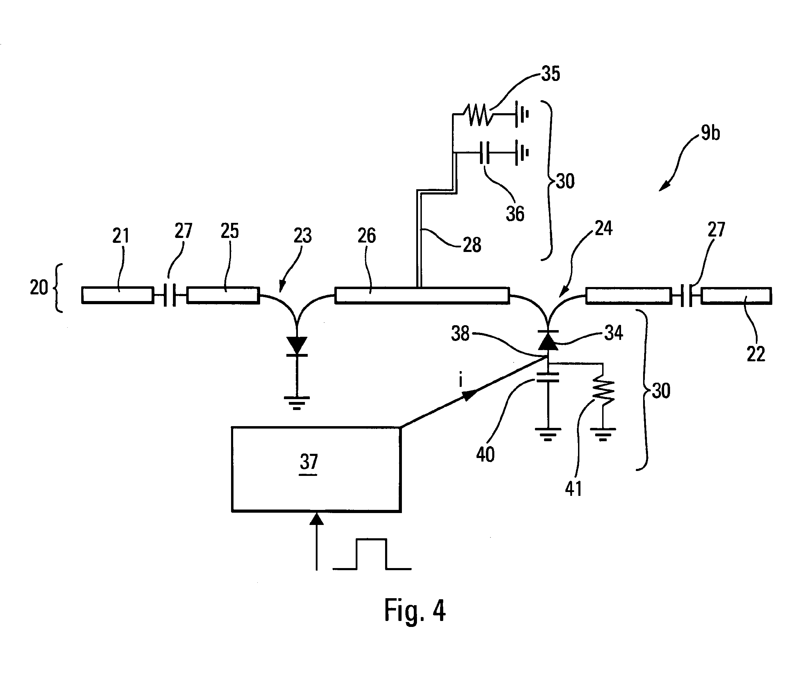

On se réfère maintenant à la figure 4 sur laquelle est représenté un second exemple de réalisation d'un limiteur 9b selon l'invention. Ce limiteur assure une protection pour des puissances de quelques Watts à quelques dizaines de Watts crête, alors que le limiteur 9a assure une protection pour des puissances de quelques dizaines de Watts à plusieurs kiloWatts crête. L'architecture du limiteur 9a a été modifiée pour former le limiteur 9b, de manière à limiter le nombre de composants utilisés.

Le circuit détecteur 30 n'est plus placé dans le circuit secondaire mais dans le circuit principal, relié au circuit principal entre le premier étage de limitation 23 et la sortie 22 du limiteur. Les diodes 34 du circuit détecteur 30 sont insérées dans la ligne principale 20, se substituant aux diodes P.I.N. du second étage de limitation 24 du limiteur 9a.

Ainsi, les diodes 34 du circuit détecteur 30 jouent un double rôle :
- participer à la limitation de la puissance de sortie du limiteur, en formant les diodes du second étage de limitation 24 ;
- injecter un courant de polarisation dans les diodes P.I.N. du premier étage 23 de limitation ;

De même que dans le limiteur 9a, le limiteur 9b comprend une entrée de polarisation 38 destinée à recevoir un courant de polarisation i externe.

Avantageusement, l'injection du courant de polarisation i externe se fait au niveau des diodes du circuit détecteur 30, via une capacité de découplage 40. Une résistance 41 est prévue en parallèle de la capacité de découplage 40 pour amener la tension de polarisation des diodes 34 au-dessus de leur seuil de conduction.

On se réfère maintenant aux figure 2 à 4. Avantageusement, la ligne principale 20 comporte un premier tronçon d'adaptation 25 situé entre l'entrée 21 et les diodes du premier étage 23 de limitation.

Le premier tronçon d'adaptation 25 est un moyen d'abaisser l'impédance du tronçon sur lequel se trouvent les diodes du premier étage 23 par rapport à l'impédance de la ligne de propagation, généralement à 50 ohms, en entrée 21 du limiteur. Il permet ainsi de limiter la puissance dissipée par les diodes du premier étage lorsqu'elles sont en mode de conduction.

Un second tronçon d'adaptation 26 de la ligne principale du limiteur est situé entre les diodes du premier étage 23 et la sortie 22 du limiteur. Le second tronçon d'adaptation 26 assure, du côté de la sortie 22 du limiteur, la réadaptation de la voie principale à la ligne de propagation sur laquelle est inséré le limiteur selon l'invention. Le second tronçon d'adaptation 26 assure à sa sortie, du côté de la sortie 22 du limiteur, une réadaptation de la ligne principale 20 à l'impédance de la ligne de propagation en entrée 21 du limiteur. Les diodes du premier étage 23 de limitation sont découplées au sens hyperfréquence de la ligne de propagation.

Les premier et second tronçons d'adaptation fonctionnent sous impédance caractéristique différente de celle de la ligne de propagation. L'impédance caractéristique de ces tronçons est de préférence strictement inférieure à celle de la ligne de propagation. Ils permettent aux diodes du premier étage 23 de travailler sous une impédance caractéristique plus faible que celle de la ligne de propagation. La puissance dissipée sur les diodes du premier étage est inférieure à celle qui aurait été dissipée sous un fonctionnement sans désadaptation de la ligne de propagation, par exemple 50 ohms. La désadaptation sous impédance caractéristique inférieure permet de limiter l'échauffement des diodes.

Les premier et second tronçons d'adaptation peuvent être des transformateurs d'impédance avec des constantes localisées sous forme de capacités et de selfs. De préférence ces tronçons comportent des constantes réparties. De préférence, le premier 25 et/ou le second 26 tronçons d'adaptation présentent une longueur d'un quart de la longueur d'onde correspondant à la fréquence moyenne de la bande de fonctionnement du limiteur.

Dans le limiteur 9a (figures 2 et 3), le circuit de détection est couplé au niveau du premier tronçon d'adaptation 25, par l'intermédiaire du coupleur 33. Le premier tronçon d'adaptation 25 permet à la fois la désadaptation et le couplage hyperfréquence. La technologie des constantes réparties permet de réaliser ces deux fonctions dans la longueur du coupleur. Dans l'exemple de réalisation de l'invention, le limiteur assure une limitation en bande S, soit de 2,7 gigahertz à 3,1 gigahertz. Pour un fonctionnement dans une autre bande de fréquences, les dimensions des circuits du limiteur sont modifiées. Le premier tronçon d'adaptation 25 est de préférence réalisé en technologie répartie dite à micro-ruban, dite encore microstrip dans la littérature anglo-saxonne. Il présente l'avantage d'être peu coûteux.

Le couplage hyperfréquence s'effectue lorsque la puissance incidente à l'entrée 21 du limiteur est suffisante pour faire entrer en conduction les diodes P.I.N. du premier étage 23. Les impédances de fermeture, par exemple cinquante ohms et cent ohms, du coupleur 33 permettent d'obtenir un couplage de l'énergie réfléchie constant dans la bande de fréquence de fonctionnement du limiteur, par exemple dans la bande S, et ceci quel que soit le niveau de conduction des diodes du premier étage 23 de limitation. L'énergie couplée est proportionnelle à l'énergie réfléchie par les diodes du premier étage 23 de limitation.

## Revendications

1. Limiteur (9a, 9b) de puissance hyperfréquence notamment pour circuit de réception radar, comprenant :
- une ligne principale (20) avec une entrée (21) et une sortie (22), l'entrée recevant un signal hyperfréquence incident,
- un premier étage (23) de limitation, inséré dans la ligne principale, formé par une ou plusieurs diodes,
- un circuit détecteur (30) avec une entrée (31) et une sortie (32), le circuit détecteur générant à sa sortie un courant répondant à la puissance du signal hyperfréquence appliqué à son entrée, l'entrée du circuit détecteur recevant une fraction du signal hyperfréquence incident, le circuit détecteur étant agencé de manière à polariser les diodes du premier étage de limitation avec le courant généré à sa sortie,
- une entrée de polarisation (38), l'entrée de polarisation recevant un courant de polarisation (i) externe, l'entrée de polarisation étant agencée de manière à polariser les diodes du premier étage de limitation avec le courant de polarisation externe,
**Caractérisé en ce que** l'entrée de polarisation est reliée à des moyens (37) pour générer un courant de polarisation synchronisé avec les impulsions du signal d'émission du radar.

2. Limiteur selon la revendication 1, dans lequel l'entrée de polarisation (38) est reliée au circuit détecteur (30).

3. Limiteur selon la revendication 1 ou 2, dans lequel le courant de polarisation (i) externe et le courant généré à la sortie (32) du circuit détecteur sont transmis à la ligne principale (20) par l'intermédiaire d'un circuit de polarisation comportant une ligne (28) et une capacité de découplage (29), la ligne (28) présentant sensiblement une longueur d'un quart de longueur d'onde à la fréquence moyenne de la bande utile du limiteur.

4. Limiteur selon l'une quelconque des revendications précédentes, dans lequel les diodes du premier étage (23) de limitation sont situées entre un premier et un second tronçons d'adaptation (25, 26) de la ligne principale, le premier tronçon d'adaptation (25), à l'entrée (21) du limiteur, étant désadapté de la ligne principale (20).

5. Limiteur selon la revendication 4, dans lequel le second tronçon d'adaptation (26) assure à sa sortie une réadaptation de la ligne principale (20) à l'impédance de la ligne de propagation en entrée (21) du limiteur.

6. Limiteur selon la revendication 4 ou 5, dans lequel le premier tronçon d'adaptation (25) présente sensiblement une longueur d'un quart de longueur d'onde à la fréquence moyenne de la bande utile du limiteur.

7. Limiteur selon l'une quelconque des revendications précédentes, dans lequel le circuit détecteur comprend une ou plusieurs diodes de type SCHOTTKY.

8. Limiteur selon l'une quelconque des revendications précédentes, comprenant en outre un second étage (24) de limitation, inséré dans la ligne principale entre le premier étage (23) de limitation et la sortie (22) du limiteur.

9. Limiteur selon l'une quelconque des revendications précédentes, dans lequel l'entrée (31) du circuit détecteur est couplée à la ligne principale (20) de manière à prélever une fraction du signal hyperfréquence incident.

10. Limiteur selon l'une quelconque des revendications 1 à 8, dans lequel le circuit détecteur (30) est relié à la ligne principale (20) entre le premier étage (23) de limitation et la sortie (22) du limiteur, la ou les diodes du circuit détecteur formant les diodes du second étage de limitation.

11. Utilisation d'un limiteur selon l'une quelconque des revendications 1 à 10.

## Claims

1. Microwave power limiter (9a, 9b), notably for a radar receiver circuit, comprising:
- a main line (20) with an input (21) and an output (22), the input receiving an incident microwave signal,
- a first limiting stage (23), inserted into the main line and formed from one or more diodes,
- a detector circuit (30) with an input (31) and an output (32), the detector circuit generating at its output a current corresponding to the power of the microwave signal applied to its input, the input of the detector circuit receiving a fraction of the incident microwave signal, the detector circuit being configured in such a manner as to bias the diodes of the first limiting stage with the current generated at its output,
- a biasing input (38), the biasing input receiving an external biasing current (i), the biasing input being configured in such a manner as to bias the diodes of the first limiting stage with the external biasing current,
**characterized in that** the biasing input is connected to means (37) for generating a biasing current synchronized with the pulses of the emission signal from the radar.

2. Limiter according to Claim 1, in which the biasing input (38) is connected to the detector circuit (30).

3. Limiter according to either of Claims 1 and 2, in which the external biasing current (i) and the current generated at the output (32) of the detector circuit are transmitted to the main line (20) by means of a biasing circuit comprising a line (28) and a decoupling capacitor (29), the line (28) having a length substantially equal to a quarter wavelength at the mean frequency of the useful band of the limiter.

4. Limiter according to any one of the preceding claims, in which the diodes of the first limiting stage (23) are situated between a first and a second matching section (25, 26) of the main line, the first matching section (25), at the input (21) of the limiter, being mismatched from the main line (20).

5. Limiter according to Claim 4, in which the second matching section (26) provides at its output a re-matching of the main line (20) to the impedance of the propagation line at the input (21) of the limiter.

6. Limiter according to either of Claims 4 and 5, in which the first matching section (25) has a length substantially equal to a quarter wavelength at the mean frequency of the useful band of the limiter.

7. Limiter according to any one of the preceding claims, in which the detector circuit comprises one or more diodes of the SCHOTTKY type.

8. Limiter according to any one of the preceding claims, also comprising a second limiting stage (24), inserted into the main line between the first limiting stage (23) and the output (22) of the limiter.

9. Limiter according to any one of the preceding claims, in which the input (31) of the detector circuit is coupled to the main line (20) in such a manner as to sample a fraction of the incident microwave signal.

10. Limiter according to any one of Claims 1 to 8, in which the detector circuit (30) is connected to the main line (20) between the first limiting stage (23) and the output (22) of the limiter, the diode or diodes of the detector circuit forming the diodes of the second limiting stage.

11. Use of a limiter according to any one of Claims 1 to 10.

## Patentansprüche

1. Mikrowellen-Leistungsbegrenzer (9a, 9b), insbesondere für eine Radar-Empfangsschaltung, der enthält:
- eine Hauptleitung (20) mit einem Eingang (21) und einem Ausgang (22), wobei der Eingang ein einfallendes Mikrowellensignal empfängt,
- eine ersten Begrenzungsstufe (23), die in die Hauptleitung eingefügt ist, gebildet aus einer oder mehreren Dioden,
- eine Erfassungsschaltung (30) mit einem Eingang (31) und einem Ausgang (32), wobei die Erfassungsschaltung an ihrem Ausgang einen Strom erzeugt, der der Leistung des Mikrowellensignals entspricht, das an ihren Eingang angelegt wird, wobei der Eingang der Erfassungsschaltung einen Bruchteil des einfallenden Mikrowellensignals empfängt, wobei die Erfassungsschaltung so ausgebildet ist, dass die Dioden der ersten Begrenzungsstufe mit dem an ihrem Ausgang erzeugten Strom polarisiert werden,
- einen Polarisationseingang (38), der einen externen Polarisationsstrom (i) empfängt, wobei der Polarisationseingang so ausgebildet ist, dass die Dioden der ersten Begrenzungsstufe mit dem externen Polarisationsstrom polarisiert werden,
**dadurch gekennzeichnet, dass** der Polarisationseingang mit Mitteln (37) verbunden ist, um einen Polarisationsstrom zu erzeugen, der mit den Impulsen des Sendesignals des Radars synchronisiert ist.

2. Begrenzer nach Anspruch 1, bei dem der Polarisationseingang (38) mit der Erfassungsschaltung (30) verbunden ist.

3. Begrenzer nach Anspruch 1 oder 2, bei dem der externe Polarisationsstrom (i) und der am Ausgang (32) der Erfassungsschaltung erzeugte Strom an die Hauptleitung (20) über eine Polarisationsschaltung übertragen werden, die eine Leitung (28) und einen Entkopplungskondensator (29) aufweist, wobei die Leitung (28) im Wesentlichen eine Länge einer Viertelwellenlänge bei der Mittelfrequenz des Nutzbands des Begrenzers aufweist.

4. Begrenzer nach einem der vorhergehenden Ansprüche, bei dem die Dioden der ersten Begrenzungsstufe (23) sich zwischen einem ersten und einem zweiten Anpassungsabschnitt (25, 26) der Hauptleitung befinden, wobei der erste Anpassungsabschnitt (25) am Eingang (21) des Begrenzers bezüglich der Hauptleitung (20) fehlangepasst ist.

5. Begrenzer nach Anspruch 4, bei dem der zweite Anpassungsabschnitt (26) an seinem Ausgang eine Neuanpassung der Hauptleitung (20) an die Impedanz der Ausbreitungsleitung am Eingang (21) des Begrenzers gewährleistet.

6. Begrenzer nach Anspruch 4 oder 5, bei dem der erste Anpassungsabschnitt (25) im Wesentlichen eine Viertelwellenlänge bei der Mittelfrequenz des Nutzbands des Begrenzers lang ist.

7. Begrenzer nach einem der vorhergehenden Ansprüche, bei dem die Erfassungsschaltung eine oder mehrere Dioden vom Typ SCHOTTKY-Diode aufweist.

8. Begrenzer nach einem der vorhergehenden Ansprüche, die außerdem eine zweite Begrenzungsstufe (24) aufweist, die in der Hauptleitung zwischen die ersten Begrenzungsstufe (23) und den Ausgang (22) des Begrenzers eingefügt ist.

9. Begrenzer nach einem der vorhergehenden Ansprüche, bei dem der Eingang (31) der Erfassungsschaltung mit der Hauptleitung (20) gekoppelt ist, um einen Bruchteil des einfallenden Mikrowellensignals zu entnehmen.

10. Begrenzer nach einem der vorhergehenden Ansprüche 1 bis 8, bei dem die Erfassungsschaltung (30) an die Hauptleitung (20) zwischen der ersten Begrenzungsstufe (23) und dem Ausgang (22) des Begrenzers angeschlossen ist, wobei die Diode(n) der Erfassungsschaltung die Dioden der zweiten Begrenzungsstufe bilden.

11. Verwendung eines Begrenzers nach einem der Ansprüche 1 bis 10.
